Europäisches Patentamt

European Patent Office

Office européen des brevets

(11) Veröffentlichungsnummer: **0 400 733**
**A2**

## (12) EUROPÄISCHE PATENTANMELDUNG

(21) Anmeldenummer: **90201319.2**

(22) Anmeldetag: **25.05.90**

(51) Int. Cl.5: **G01R 33/34**

(30) Priorität: **31.05.89 DE 3917619**

(43) Veröffentlichungstag der Anmeldung:
**05.12.90 Patentblatt 90/49**

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**
(84) **DE**

Anmelder: **N.V. Philips' Gloeilampenfabrieken**
**Groenewoudseweg 1**
**NL-5621 BA Eindhoven(NL)**
(84) **FR GB NL**

(72) Erfinder: **Kuhn, Michael, Dr.-Ing.**
**Süntelstrasse 77**
**D-2000 Hamburg 61(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Spulenanordnung für die volumenselektive Kernresonanz-Spektroskopie.**

(57) Die Erfindung betrifft eine Spulenanordnung, die sich insbesondere für die volumenselektive Kernresonanz-Spektroskopie eignet. Diese Spulenanordnung enthält außer der Spule zum Erzeugen der Hochfrequenzimpulse bzw. zum Empfangen der Kernresonanzsignale eine Korrekturspule, der ein Gleichstrom zugeführt wird, wodurch diese Spule ein inhomogenes Feld erzeugt, das die im selektierten Volumenbereich bestehenden Inhomogenitäten des stationären Magnetfeldes kompensieren kann. Dadurch wird das Magnetfeld in diesem Bereich so homogen, daß spektroskopische Untersuchungen auch in Bereichen durchgeführt werden können, in denen sich die magnetische Suszeptibilität räumlich stark ändert.

Fig.1

## Spulenanordnung für die volumenselektive Kernresonanz-Spektroskopie

Die Erfindung betrifft eine Spulenanordnung für die volumenselektive Kernresonanz-Spektroskopie mit einer an einen Hochfrequenzerzeuger und/oder einen Hochfrequenzempfänger anschließbaren Hochfrequenzspule zur Erzeugung und/oder zum Empfang von magnetischen Hochfrequenzfeldern. Bei der volumenselektiven Kernresonanzspektroskopie werden die in einem kleinen Bereich - dem selektierten Volumen - innerhalb eines zu untersuchenden Patienten erzeugten Kernresonanzsignale einer spektralen Analyse unterzogen. Die so erhaltenen Spektren ergeben Aufschluß über die in dem selektierten Volumen enthaltenen Substanzen. Derartige Verfahren sind bekannt einschließlich der dazu erforderlichen Spulenanordnungen (vergl. z.B. EP-OS 233 675). Diese enthalten entweder eine einzige Hochfrequenzspule zum Erzeugen magnetischer Hochfrequenzimpulse und zum Empfangen der im Volumenbereich erzeugten Kernresonanzsignale oder aber gesonderte Hochfrequenzspulen zum Erzeugen von Hochfrequenzimpulsen einerseits und zum Empfangen der Kernresonanzsignale andererseits.

Derartige Untersuchungen werden bekanntlich in Anwesenheit eines starken stationären Magnetfeldes durchgeführt, wobei es außerordentlich wichtig ist, daß dieses Magnetfeld in dem zu untersuchenden Volumenbereich homogen ist. Die Abweichung des Magnetfeldes, bezogen auf dessen Mittelwert, muß überall innerhalb des untersuchten Volumens weit unter 1 ppm liegen.

Um die Homogenität zu verbessern, werden sogenannte Shim-Spulen benutzt, deren Gleichströme individuell so eingestellt werden, daß sich insgesamt ein möglichst homogenes Feld ergibt. Diese fest in dem Kernspinuntersuchungsgerät eingebauten Spulen haben eine Öffnung, die ausreicht, einen zu untersuchunden Patienten aufzunehmen.

Es hat sich aber gezeigt, daß die mit diesen Spulen erreichbare Homogenität begrenzt ist und daß selbst dann, wenn der Patient in ein exakt homogenes Magnetfeld eingeführt würde, das Magnetfeld innerhalb des Patienten eine Inhomogenität von mehreren ppm aufweist. Diese ist auf starke lokale Änderungen der magnetischen Suszeptibilität zurückzuführen, wodurch das Magnetfeld aus dem Inneren des menschlichen Körpers verdrängt wird.

Aufgabe der vorliegenden Erfindung ist es, die Inhomogenitäten des Magnetfeldes noch weiter zu verringern.

Ausgehend von einer Spulenanordnung der eingangs genannten Art wird diese Aufgabe erfindungsgemäß dadurch gelöst, daß in definiertem räumlichen Abstand in bezug auf die Hochfrequenzspule eine an eine Gleichstromquelle anschließbare Korrekturspule vorgesehen ist, die in dem von der Hochfrequenzspule beaufschlagten Bereich ein sich räumlich änderndes Magnetfeld erzeugt.

Durch geeignete Anordnung der Spulenanordnung und durch geeignete Einstellung des Gleichstroms durch die Korrekturspule läßt sich erreichen, daß - jedenfalls in einem kleinen Volumenbereich - der inhomogene Verlauf des Magnetfeldes den entsprechenden Verlauf, der sich ohne diese Spule ergibt, gerade kompensiert. Auf diese Weise läßt sich die Homogenität des Magnetfeldes in einem Maße verbessern, daß spektroskopische Untersuchungen auch in den Bereichen des menschlichen Körpers möglich sind, in denen sich größere Suszeptibilitätsunterschiede auswirken.

Die Erfindung wird nachstehend anhand der Zeichnung näher dargestellt. Es zeigen

Fig. 1 eine erfindungsgemäße Spulenanordnung bei einer Untersuchung am menschlichen Schädel und

Fig. 2 ein Blockschaltbild zur Erläuterung des elektrischen Anschlusses dieser Spulen.

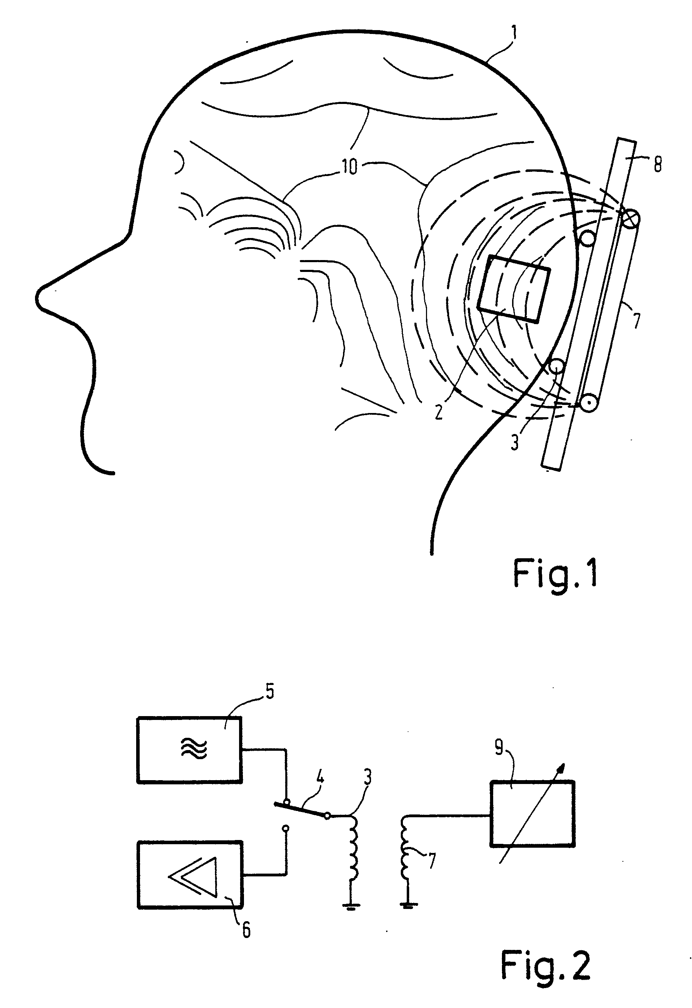

In Fig. 1 ist mit 1 die Kontur eines menschlichen Schädels bezeichnet, in dem ein Volumenbereich 2 spektroskopisch untersucht werden soll. Bei der Untersuchung befindet sich der Schädel im Innern eines Magneten, der ein homogenes stationäres Magnetfeld mit einer Magnetflußdichte von z.B. 4 Tesla erzeugt. wegen der unterschiedlichen magnetischen Suszeptibilität innerhalb und außerhalb des Schädels wird das magnetische Feld aus dem Inneren des Kopfes verdrängt, nimmt also nach Innen hin ab. In der Zeichnung verbinden die dünnen Linien 10 die Orte gleicher magnetischer Feldstärke, wobei zwischen benachbarten Linien ein Feldstärkeunterschied von 0,16 ppm besteht. Man erkennt, daß sich im zentralen Bereich des Hirns ein weitgehend homogenes Feld ergibt, während das Magnetfeld im hinteren Teil des Schädels, insbesondere aber im Bereich der Augenhöhlen stark inhomogen ist. Kernresonanzspektroskopische Untersuchungen in diesem Teil des Schädels waren daher bisher nicht möglich.

Zur spektroskopischen Untersuchung eines Volumenbereichs 2 im hinteren Schädel ist im Bereich der hinteren Schädelwand eine Spulenanordnung positioniert, die eine als Oberflächenspule ausgebildete Hochfrequenzspule 3 umfaßt, die eine Ringform haben kann. Die Hochfrequenzspule 3 kann sowohl Hochfrequenzimpulse erzeugen als auch die im Volumenbereich 2 entstehenden Kernresonanzsignale aufnehmen.

Wie in Fig. 2 angedeutet, ist die Hochfrequenzspule 3 zu diesem Zweck über einen Umschalter 4 wahlweise mit einem Hochfrequenzsender 5 oder mit einem Hochfrequenzempfänger 6 verbindbar. Es ist aber auch möglich, die Hochfrequenzspule 3 nur zum Emfpang benutzen und eine weitere Hochfrequenzspule, beispielsweise eine sogenannte Kopfspule, die den Kopf des Patienten umschließt, zur Erzeugung der Hochfrequenzimpulse zu verwenden. Die Selektion des Volumenbereichs 2 erfolgt mit Hilfe von nicht näher dargestellten Gradientenspulen, die Magnetfelder mit konstantem Gradienten erzeugen können - beispielsweise so, wie in der EP-A 233675 näher erläutert.

Die Spulenanordnung umfaßt noch eine weitere Spule 7, die im folgenden Korrekturspule genannt wird und die sich in räumlich definierter Lage in bezug auf die Hochfrequenzspule 3 befindet. Zu diesem Zweck können die beiden ebenen Spulen 3 und 7 an den beiden Seiten eines plattenförmigen Trägerkörpers 8 befestigt sein, der aus einem geeigneten Material (z.B. Plexiglas) besteht. Die Korrekturspule 7 ist an eine Stromquelle 9 angeschlossen, deren Strom hinsichtlich seiner Amplitude und seiner Polarität einstellbar ist.

In Fig. 1 sind mit gestrichelten Linien die Linien gleicher Feldstärke angedeutet, die sich ergeben, wenn das für die Untersuchung erforderliche stationäre homogene Magnetfeld abgeschaltet ist und nur die Korrekturspule 7 von einem Gleichstrom durchflossen wird. Die magnetische Feldstärke nimmt ebenfalls zum Innern des Schädels hin ab - nach einer nichtlinearen Funktion - und man erkennt, daß die gestrichelten Linien im Bereich des hinteren Teils des Schädels näherungsweise die gleiche Form haben wie die dünn ausgezogenen Linien 10 gleicher magnetischer Feldstärke, die aus dem homogenen stationären äußeren Magnet feld (allein) resultieren. Durch geeignete Wahl der Stromrichtung und der Amplitude des Gleichstroms in der Korrekturspule 7 ist es also möglich, die durch die Unterschiede in der magnetischen Suszeptibilität hervorgerufene Inhomogenität des stationären Magnetfeldes durch die Inhomogenität des von der Korrekturspule erzeugten Magnetfeldes zumindest in dem Volumenbereich 2 und seiner näheren Umgebung weitgehend zu kompensieren. Das resultierende Magnetfeld in diesem Bereich wird daher so homogen, daß die in diesem Bereich erzeugten Kernresonanzsignale einer spektroskopischen Analyse zugänglich sind.

Da bei einer gegebenen Position des Schädels angesichts vergleichbarer Anatomie verschiedener Patienten jeweils gleichartige Inhomogenitäten auftreten, eignet sich die Spulenanordnung 3, 7 für die spektroskopische Untersuchung des gesamten hinteren Schädels. Derartige Spulenanordnungen sind auch für andere anatomische Regionen einsetzbar, wobei je nach Ausmaß der Inhomogenität auch wesentlich komplexere Strukturen erforderlich werden können, die sich aber mit entsprechenden Rechenprogrammen bei bekannter Feldverteilung innerhalb des Patienten berechnen lassen.

Die einfachste Möglichkeit, den richtigen Strom einzustellen, besteht darin, diesen Strom in Stufen zu verändern und dabei jeweils eine oder mehrere Sequenzen zur Volumenselektion zu erzeugen, die Abklingzeit oder die Linienbreite des resultierenden Kernresonanzsignals zu analysieren und letztlich den Strom eingestellt zu lassen, bei dem sich die geringste Linienbreite bzw. die größte Abklingzeit ergibt. Die so gefundene Einstellung kann gegebenenfalls mit Hilfe des bekannten Verfahrens kontrolliert werden, bei dem die Sequenzen so gestaltet sind, daß in dem Kernspintomogramm die Linien in gleicher Feldstärke sichtbar werden (vgl. Z. Naturforsch. 43a, Seiten 291-296; 1988). Da wegen des vergleichsweise geringen Abstandes der Korrekturspule von dem zu untersuchenden Volumenbereich 2 schon geringe Spulenströme ausreichen, um die zur Kompensation der Inhomogenitäten erforderlichen Gradienten des Magnetfeldes zu produzieren, ist der Aufwand für die Stromquelle 9 wesentlich geringer als der für die Stromquellen zur Speisung der eingangs erwähnten Shim-Spulen.

Zur Volumenselektion ist es erforderlich, während einer Sequenz magnetische Gradientenfelder ein- und auszuschalten. Diese Schaltvorgänge können in der Korrekturspule 7 Störsignale hervorrufen. Um diese zu vermeiden, ist es möglich, die Korrekturspule 7 während dieser Schaltvorgänge abzuschalten. Dadurch wird jedoch die Feldverteilung beeinflußt und damit das selektierte Volumen. Versorgt man stattdessen die Spule 7 anstatt von einer Gleichstromquelle von einem Audioverstärker (mit genügend großem Innenwiederstand), dann können die in der Spule 7 induzierten Störsignale kompensiert werden. Dazu werden die induzierten Störsignale in der Korrekturspule in einem Vorexperiment (nach Positionierung des Patienten) registriert (mittels eines Analog-Digital-Wandlers und eines Speichers, der von einem Microprozessor in geeigneter Weise verwaltet wird) und dann während der eigentlichen Messung invers dem Gleichstrom überlagert.

## Ansprüche

1. Spulenanordnung für die volumenselektive Kernresonanz-Spektroskopie mit einer an einen Hochfrequenzerzeuger und/oder einen Hochfrequenzempfänger anschließbaren Hochfrequenzerzeuger und/oder einen Hochfrequenzempfänger anschließbaren Hochfrequenzspule zur Erzeugung und/oder zum Empfang von magnetischen Hochfrequenzfeldern, **dadurch gekennzeichnet**, daß in definiertem räumlichen Abstand in bezug auf die Hochfrequenzspule (3) eine an eine Stromquelle (9) anschließbare Korrekturspule (7) vorgesehen ist, die in dem von der Hochfrequenzspule beaufschlagten Bereich ein sich räumlich änderndes Magnetfeld erzeugt.

2. Anordnung nach Anspruch 1, **dadurch gekennzeichnet**, daß die Hochfrequenzspule als Oberflächenspule (3) ausgebildet ist.

3. Anordnung nach Anspruch 2, **dadurch gekennzeichnet**, daß die beiden Spulen (3, 7) in parallelen Ebenen an einem gemeinsamen Träger (8) befestigt sind.

Fig.1

Fig.2

PHD 89-081